# EUROPÄISCHE PATENTANMELDUNG

(11) **EP 1 703 641 A1**
(43) Veröffentlichungstag der Anmeldung: **20.09.2006**
(21) Anmeldenummer: 06005147.1
(22) Anmeldetag: 14.03.2006
(51) Int. Cl.: H03K 17/96, F24C 7/08

(54) **Optischer Berührungsschalter mit hoher Funktionssicherheit und Verfahren zum Betrieb desselben**

(30) Priorität: 16.03.2005 DE 102005012001
(71) Anmelder: Diehl AKO Stiftung & Co. KG, 88239 Wangen (DE)
(72) Erfinder: Schildbach, Joachim, 63843 Niedernberg (DE)
(74) Vertreter: Diehl Patentabteilung

(57) **Zusammenfassung**

Es wird eine elektrische Schaltvorrichtung, insbesondere zur Bedienung eines Haushaltsgeräts, vorgeschlagen, die wenigstens einen berührungsempfindlichen Tastschalter, der einen ersten optischen Sensor (12) aufweist, der hinter einer für die elektromagnetische Strahlung des optischen Sensors zumindest teildurchlässigen Abdeckung (10) angeordnet ist; und eine Auswerteschaltung zum Auswerten eines von dem ersten optischen Sensor (12) des wenigstens einen Tastschalters zugeführten Messwerts enthält, wobei dem ersten optischen Sensor (12) des wenigstens einen Tastschalters ein zweiter optischer Sensor (20) zugeordnet ist, der ebenfalls hinter der Abdeckung (10) angeordnet ist, zum Erzeugen eines Referenzwerts; und die Auswerteschaltung den von dem ersten optischen Sensor (12) des wenigstens einen Tastschalters zugeführten Messwert mit dem von dem zweiten optischen Sensor (20) des wenigstens einen Tastschalters zugeführten Referenzwert vergleicht. Hierdurch ist es zum Beispiel möglich, eine Fehlfunktion des jeweiligen Tastschalters zu beurteilen, eine Empfindlichkeit des jeweiligen Tastschalters zu berücksichtigen oder eine fehlerhaft beurteilte Betätigung des jeweiligen Tastschalters zu erkennen.

## Beschreibung

Die vorliegende Erfindung betrifft eine elektrische Schaltvorrichtung nach dem Oberbegriff des Patentanspruchs 1 sowie ein Verfahren zum Auswerten eines Messwerts nach dem Oberbegriff des Patentanspruchs 8. Die vorliegende Erfindung betrifft dabei insbesondere Haushaltsgeräte, deren elektrische Schaltvorrichtungen mit berührungsempfindlichen Tastschaltern versehen sind.

Der grundsätzliche Aufbau und das Grundprinzip eines solchen berührungsempfindlichen Tastschalters sind zum Beispiel aus der DE 40 07 971 A1 bekannt. Der berührungsempfindliche Tastschalter weist wenigstens einen optischen Sensor mit einem elektromagnetische Strahlung aussendenden Sender und einem elektromagnetische Strahlung empfangenden Empfänger auf, die hinter einer für die elektromagnetische Strahlung zumindest teildurchlässigen Abdeckung angeordnet sind. Eine vorteilhafte Anwendung derartiger berührungsempfindlicher Tastschalter ist zum Beispiel der Einsatz in Bedieneinrichtungen von Haushaltsgeräten, wie Kochherden, Glaskeramik-Kochfeldern, Mikrowellenherden und dergleichen, bei denen der Tastschalter, damit er einfach zu bedienen und auch zu reinigen ist, hinter einer Abdeckung, wie beispielsweise einer Glasplatte oder Glaskeramikplatte angeordnet ist.

Bei berührungsempfindlichen Tastschaltern ist das System stets bestrebt, aus dem analogen Messwert der Sensorik die digitale Aussage "Taste gedrückt" oder "Taste nicht gedrückt" bzw. "Beginn eines Tastendrucks" oder "Ende eines Tastendrucks" zu generieren. Bei der Bedienung von Haushaltsgeräten, wie Kochherden, Glaskeramik-Kochfeldern, Mikrowellenherden und dergleichen, spielt dabei die Funktionssicherheit der berührungsempfindlichen Tastschalter eine wichtige Rolle.

Zum Beispiel muss sich auch bei einem defekten Tastschalter eine Kochmulde noch abschalten lassen; falls dies nicht möglich ist, muss sich die Kochmulde selbst abschalten. Des weiteren müssen die berührungsempfindlichen Tastschalter auch bei unterschiedlichen Einbaubedingungen, wie zum Beispiel unterschiedlichen Abständen der optischen Sensoren zur Abdeckung aufgrund von Montagetoleranzen und -fehlern oder von temperaturbedingten Verwindungen der Leiterplatte der elektrischen Schaltvorrichtung, zuverlässig bedienbar sein.

Ferner muss gewährleistet sein, dass ein berührungsempfindlicher Tastschalter zum Beispiel bei einem plötzlichen Lichteinfall durch das Einschalten einer Leuchte oder beim Reinigen eines Glaskeramik-Kochfeldes nicht fehlerhaft als durch einen Benutzer betätigt beurteilt wird.

Es ist daher eine Aufgabe der vorliegenden Erfindung, eine elektrische Schaltvorrichtung mit wenigstens einem berührungsempfindlichen Tastschalter mit einem optischen Sensor bereitzustellen, die eine verbesserte Funktionssicherheit besitzt. Es ist eine weitere Aufgabe der vorliegenden Erfindung, ein Verfahren zum Auswerten eines Messwerts von einem optischen Sensor eines berührungsempfindlichen Tastschalters vorzusehen, das die Funktionssicherheit des berührungsempfindlichen Tastschalters erhöht.

Gemäß einem ersten Aspekt wird die obige Aufgabe gelöst durch eine elektrische Schaltvorrichtung mit den Merkmalen des Anspruchs 1. Gemäß einem zweiten Aspekt wird die obige Aufgabe gelöst durch eine Auswerteverfahren mit den Merkmalen des Anspruchs 8. Vorteilhafte Ausgestaltungen und Weiterbildungen der Erfindung sind Gegenstand der jeweiligen Unteransprüche.

Die elektrische Schaltvorrichtung der Erfindung weist wenigstens einen berührungsempfindlichen Tastschalter, der einen ersten optischen Sensor aufweist, der hinter einer für die elektromagnetische Strahlung des optischen Sensors zumindest teildurchlässigen Abdeckung angeordnet ist, und eine Auswerteschaltung zum Auswerten eines von dem ersten optischen Sensor des wenigstens einen Tastschalters zugeführten Messwerts auf, wobei dem ersten optischen Sensor des wenigstens einen Tastschalters ein zweiter optischer Sensor, der ebenfalls hinter der Abdeckung angeordnet ist, zum Erzeugen eines Referenzwerts zugeordnet ist, und wobei die Auswerteschaltung den vom ersten optischen Sensor des wenigstens einen Tastschalters zugeführten Messwert mit dem vom zweiten optischen Sensor des wenigstens einen Tastschalters zugeführten Referenzwert vergleicht. Üblicherweise sind mehrere berührungsempfindliche Tastschalter mit jeweils einem ersten optischen Sensor vorgesehen, und jedem ersten optischen Sensor der mehreren Tastschalter ist ein zweiter optischer Sensor zugewiesen.

Durch das Vorsehen der zweiten optischen Sensoren und das Vergleichen der Messwerte mit Referenzwerten ist es zum Beispiel möglich, eine Fehlfunktion des jeweiligen Tastschalters zu beurteilen, eine tatsächliche Empfindlichkeit des jeweiligen Tastschalters zu berücksichtigen oder eine fehlerhaft beurteilte Betätigung des jeweiligen Tastschalters zu erkennen, sodass die Funktionssicherheit der elektrischen Schaltvorrichtung deutlich verbessert ist.

Vorzugsweise weist die Schaltvorrichtung ferner einen dritten optischen Sensor, der ebenfalls hinter der Abdeckung angeordnet ist, zum Erzeugen eines Hauptreferenzwerts auf, und die Auswerteschaltung vergleicht die von den zweiten optischen Sensoren der Tastschalter zugeführten Referenzwerte mit dem vom dritten optischen Sensor zugeführten Hauptreferenzwert. Die elektrische Schaltvorrichtung kann dabei auch zwei nebeneinander angeordnete dritte optische Sensoren zum Erzeugen jeweils eines Hauptreferenzwerts aufweisen.

Die dritten optischen Sensoren dienen dem Erkennen einer etwaigen Fehlfunktion eines zweiten optischen Sensors, sodass die Funktionssicherheit der elektrischen Schaltvorrichtung weiter verbessert ist.

In einer Ausgestaltung der Erfindung ist jedem ersten optischen Sensor der Tastschalter an der Abdeckung eine Bedruckung zugeordnet, während den zweiten und dritten optischen Sensoren keine Bedruckungen an der Abdeckung zugeordnet sind.

In einer weiteren Ausgestaltung der Erfindung sind die ersten optischen Sensoren, die zweiten optischen Sensoren und gegebenenfalls die dritten optischen Sensoren auf einer gemeinsamen Leiterplatte angeordnet.

Das Verfahren zum Auswerten eines Messwerts, der von einem ersten optischen Sensor eines berührungsempfindlichen Tastschalters erfasst wird, der hinter einer für die elektromagnetische Strahlung des optischen Sensors zumindest teildurchlässigen Abdeckung angeordnet ist, zeichnet sich dadurch aus, dass der von dem ersten optischen Sensor des Tastschalters zugeführte Messwert mit einem von einem zweiten optischen Sensor, der dem ersten optischen Sensor des Tastschalters zugeordnet ist, zugeführten Referenzwert verglichen wird. Üblicherweise werden mehrere Messwerte ausgewertet, die jeweils von einem ersten optischen Sensor eines Tastschalters erfasst werden, wobei dann die von den ersten optischen Sensoren der Tastschalter zugeführten Messwerte jeweils mit einem von einem zweiten optischen Sensor, der dem jeweiligen zweiten optischen Sensor des Tastschalter zugeordnet ist, zugeführten Referenzwert verglichen werden.

Ferner werden vorzugsweise die von den zweiten optischen Sensoren der Tastschalter zugeführten Referenzwerte mit einem von einem dritten optischen Sensor zugeführten Hauptreferenzwert verglichen.

Basierend auf dem Vergleich zwischen dem vom ersten optischen Sensor des Tastschalters zugeführten Messwert und dem vom zweiten optischen Sensor zugeführten Referenzwert kann zum Beispiel eine Fehlfunktion des jeweiligen Tastschalters beurteilt werden, eine Empfindlichkeit des jeweiligen Tastschalters berücksichtigt werden, eine fehlerhaft beurteilte Betätigung des jeweiligen. Tastschalters erkannt werden und dergleichen.

Obige sowie weitere Merkmale und Vorteile der Erfindung werden aus der nachfolgenden Beschreibung eines bevorzugten, nicht-einschränkenden Ausführungsbeispiels unter Bezugnahme auf die beiliegenden Zeichnungen besser verständlich. Darin zeigen:
- Fig. 1: eine schematische Teilseitenansicht einer elektrischen Schaltvorrichtung für ein Glaskeramik-Kochfeld gemäß der vorliegenden Erfindung;
- Fig. 2: einen schematischen Schaltungsaufbaus eines optischen Sensors der elektrischen Schaltvorrichtung der vorliegenden Erfindung; und
- Fig. 3: eine Draufsicht einer elektrischen Schaltvorrichtung für ein Glaskeramik-Kochfeld gemäß der vorliegenden Erfindung.

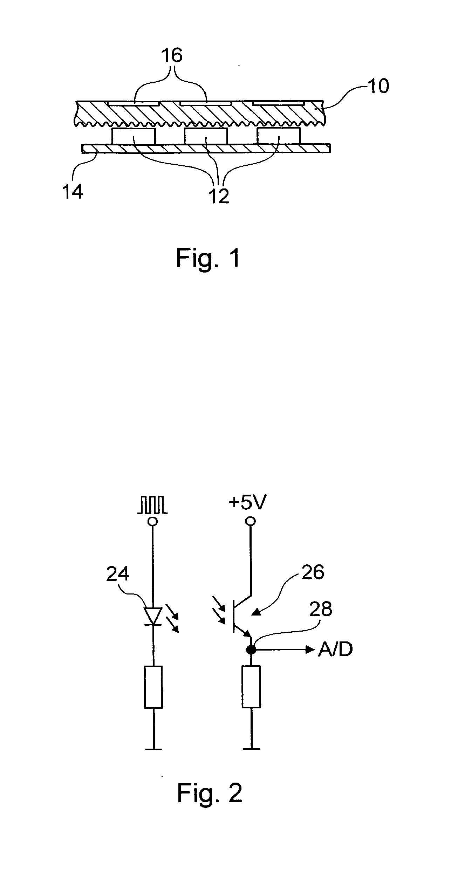

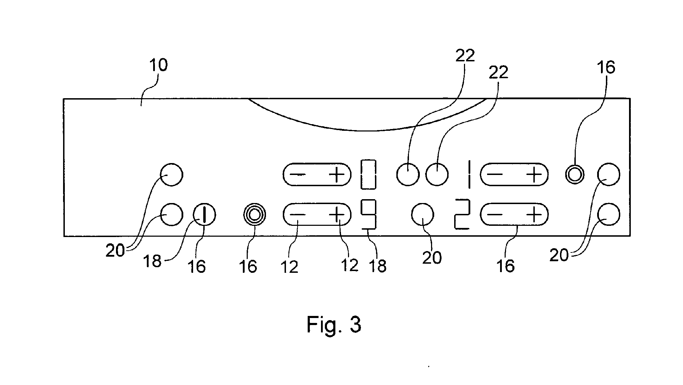

In Fig. 1 ist zunächst vereinfacht der Aufbau einer elektrischen Schaltvorrichtung dargestellt, bei welcher die vorliegende Erfindung anwendbar ist. Der Aufbau und die Funktionsweise der elektrischen Schaltvorrichtung der Erfindung wird anschließend unter Bezugnahme auf Fig. 2 und 3 am Beispiel einer elektrischen Schaltvorrichtung eines Glaskeramik-Kochfeldes mit mehreren berührungsempfindlichen Infrarot-Tastschaltern erläutert.

Die vorliegende Erfindung ist aber selbstverständlich nicht nur auf elektrische Schaltvorrichtungen von Glaskeramik-Kochfeldern mit berührungsempfindlichen Infrarot-Tastschaltern anwendbar. Vielmehr kann die vorliegende Erfindung auch bei anderen Haushaltsgeräten, wie beispielsweise Kochherden, Mikrowellenöfen, Wäschetrocknern, Waschmaschinen und dergleichen einsetzbar. Außerdem sind die berührungsempfindlichen Tastschalter nicht auf optische Sensoren im Infrarotbereich beschränkt.

Wie in Fig. 1 dargestellt, enthält eine elektrische Schaltvorrichtung zur Bedienung eines Glaskeramik-Kochfeldes mehrere berührungsempfindliche Tastschalter, die jeweils wenigstens einen ersten optischen Sensor 12 aufweisen. Die ersten optischen Sensoren sind auf einer gemeinsamen Leiterplatte 14 montiert und hinter einer für die elektromagnetische Strahlung der ersten optischen Sensoren 12 zumindest teildurchlässigen Glaskeramikplatte als Abdeckung 10 angeordnet. Auf oder in der Glaskeramikplatte 10 ist für jeden der ersten optischen Sensoren 12 der Tastschalter eine entsprechende Bedruckung 16 vorgesehen, damit der Benutzer die Position und die Art des jeweiligen Tastschalters erkennen kann. Dieser Aufbau entspricht auch dem einer herkömmlichen elektrischen Schaltvorrichtung.

Ein optischer Sensor 12, zum Beispiel ein Infrarot-Sensor, enthält üblicherweise eine Infrarot-Sendediode 24 und einen Infrarot-Empfängertransistor 26, wie in Fig. 2 veranschaulicht. Zur Beurteilung einer Betätigung des zugehörigen Tastschalters wird an einem Messpunkt 28 die Spannung bei ein- und ausgeschalteter Sendediode 24 erfasst und einem A/D-Umsetzer zugeführt.

Herkömmlicherweise wird angenommen, dass die Einbausituation für alle ersten optischen Sensoren 12 der Tastschalter unter der Abdeckung 10 identisch ist, d.h. alle Sensoren 12 haben den gleichen Abstand zur Abdeckung 10 und die Abdeckung 10 besitzt über die gesamte Fläche eine gleichmäßige Charakteristik zur Übertragung der für die Infrarot-Sensoren 12 notwendigen physikalischen Effekte.

In der Praxis unterschieden sich die optischen Sensoren 12 der Tastschalter jedoch schon aufgrund der verschiedenen Bedruckungen 16 der Abdeckung 10 voneinander. Die Empfindlichkeit der optischen Sensoren 12 in Bezug auf die Bedruckung 16 wird durch die optische Charakteristik der Bedruckung 16 (Lichtdurchlässigkeit, Reflexionsvermögen, Absorptionsvermögen) und die Intensität der Bedruckung 16 (prozentuale Abdeckung des Sensorbereichs durch die Bedruckung) beeinflusst. Bei dunkel eingefärbten Abdeckungen 10 sind die Bedruckungen 16 im Allgemeinen hell gehalten und daher meist reflektierend bis durchlässig. Vergleicht man hier zum Beispiel eine weiße reflektierende Bedruckung 16 mit einer hellgrauen durchlässigen Bedruckung auf einer dunklen Abdeckung, so wird bei ausgeschalteter Sendediode des optischen Sensors 12 bei der weißen Bedruckung eine kleinere Spannung gemessen als bei der durchlässigen hellgrauen Bedruckung, während bei eingeschalteter Sendediode des optischen Sensors 12 die gemessene Spannung (aufgrund Fremdlicht + gesendetes und reflektiertes Licht) bei der weißen Bedruckung größer wird. Außerdem verringern großflächige und gleichzeitig reflektierende oder absorbierende Bedruckungen 16 den optischen Einfluss der Sensoren 12.

Einen weiteren Einfluss auf die Empfindlichkeit der optischen Sensoren 12 hat der Abstand der Sensorik zur Unterseite der Abdeckung 10. Ist die Leiterplatte 14 mit den optischen Sensoren 12 zum Beispiel etwas schräg eingebaut, so reagieren die optischen Sensoren 12 und damit die zugehörigen Tastschalter mit unterschiedlichen Empfindlichkeiten. Eine die Empfindlichkeit beeinflussende Abstandsänderung der Sensoren 12 von der Abdeckung 10 kann auch durch eine temperaturbedingte Verwindung der Leiterplatte 14 im Laufe der Zeit bewirkt werden.

Durch die in der Praxis auftretenden Unterschiede der Empfindlichkeit bei den optischen Sensoren 12 reagiert die elektrische Schaltvorrichtung auf einen Benutzer bei verschiedenen Tastschaltern in unterschiedlicher Weise, was die Bedienung für den Benutzer schwieriger macht und ihn verunsichert.

Neben Möglichkeit einer gleichmäßigen Bedienung der Tastschalter einer elektrischen Schaltvorrichtung wird auch die Funktionssicherheit der Tastschalter gefordert. Falls eine der in Fig. 2 dargestellten Komponenten des optischen Sensors 12 ausfällt bzw. fehlerhaft ist, so würde am Messpunkt 28 zum Beispiel immer eine konstante Spannung gemessen werden. In einem solchen Fall müsste der fehlerhafte optische Sensor bzw. Tastschalter durch die elektrische Schaltvorrichtung selbst erkannt werden, um gegebenenfalls eine automatische Notabschaltung einer Kochmulde zu veranlassen.

Ferner besteht bei herkömmlichen elektrischen Schaltvorrichtungen des obigen Aufbaus die Möglichkeit, dass die elektrische Schaltvorrichtung bei einem plötzlichen Lichteinfall (z.B. durch Sonneneinstrahlung oder Einschalten einer Leuchte) auf einen optischen Sensor 12 dies fälschlicherweise als eine Betätigung des Tastschalters durch einen Benutzer interpretiert und eine Kochmulde einschaltet. Auch beim Reinigen eines Glaskeramik-Kochfeldes kann es zum Beispiel beim Abwischen von Flüssigkeiten bei einem optischen Sensor zu einem Messwertverlauf kommen, der fälschlicherweise als eine Betätigung des Tastschalters beurteilt werden kann. Zur Erhöhung der Funktionssicherheit der elektrischen Schaltvorrichtung müssen auch diese Fehlfunktionen ausgeschlossen werden.

Um die Bedienfreundlichkeit zu verbessern und die Funktionssicherheit zu erhöhen, wurde die elektrische Schaltvorrichtung erfindungsgemäß weiterentwickelt, wie nachfolgend unter Bezugnahme auf Fig. 3 beschrieben.

Fig. 3 zeigt eine Draufsicht auf das Bedienfeld eines Glaskeramik-Kochfeldes. Es sind daher insbesondere die Bedruckungen 16 der Tastschalter bzw. deren optischen Sensoren 12 sowie Signalelemente 18 erkennbar. Die in Fig. 3 dargestellten +/- - Tastschalter zum Einstellen einer Kochstufe einer zugehörigen Kochmulde enthalten jeweils zwei erste optische Sensoren 12 der oben beschriebenen Art, um die Kochstufe zu erhöhen bzw. zu erniedrigen. Neben den Tastschaltern befindet sich jeweils ein Signalelement 18 zum Anzeigen der aktuell eingestellten Kochstufe (z.B. 0 ... 9).

Gemäß der Erfindung ist den ersten optischen Sensoren 12 der Tastschalter jeweils ein zweiter optischer Sensor 20 zugeordnet, der grundsätzlich analog dem ersten optischen Sensor 12 aufgebaut ist. Die zweiten optischen Sensoren 20 sind in der Nähe der ersten optischen Sensoren 12 ebenfalls hinter der Abdeckung 10 und bevorzugt auf der gleichen Leiterplatte 14 angeordnet, aber mit keinen Bedruckungen 16 versehen, sodass sie für den Benutzer nicht erkennbar sind. Einer dieser zweiten optischen Sensoren 20 ist im gezeigten Ausführungsbeispiel als dritter optischer Sensor 22 mit zwei nebeneinander angeordneten Sensoren ausgebildet. Der dritte optische Sensor 22 kann aber auch unabhängig von den Tastschaltern an einer anderen Stelle des Bedienfeldes vorgesehen sein.

Die zweiten optischen Sensoren 20 erzeugen einen Referenzwert und dienen als Referenzsensoren zu den ersten optischen Sensoren 12; der dritte optische Sensor 22 erzeugt einen Hauptreferenzwert und dient als Hauptreferenzsensor zu den Referenzsensoren.

Durch Vergleichen der von den ersten optischen Sensoren 12 erzeugten Messwerten mit den von den zweiten optischen Sensoren 20 erzeugten Referenzwerten kann auf einfache Weise erkannt werden, ob ein erster optischer Sensor 12 ausgefallen ist, kann die Empfindlichkeit eines ersten optischen Sensors 12 berücksichtigt werden, und kann eine fälschlicherweise beurteilte Tastschalterbetätigung erkannt werden.

Ist zum Beispiel ein erster optischer Sensor 12 ausgefallen, so wird an seinem Messpunkt 28 immer eine konstante Spannung gemessen. Bei dem zugehörigen zweiten optischen Sensor 20 wird dagegen eine vom Lichteinfall abhängige variable Spannung gemessen. So kann durch Vergleichen des Messwerts mit dem Referenzwert einfach erkannt werden, dass der erste optische Sensor 12 defekt ist. Da außerdem der Abstand des zweiten optischen Sensors 20, der in der Nähe des ersten optischen Sensors 12 angeordnet ist, zur Abdeckung 10 im Wesentlichen gleich jenem für den ersten optischen Sensor 12 ist, kann die abstandsabhängige Empfindlichkeit des ersten optischen Sensors 12 einfach berücksichtigt werden.

Werden darüber hinaus auch die Referenzwerte aller zweiten optischen Sensoren 20 miteinander verglichen, so kann die Abstandssituation der gesamten Leiterplatte 14 abgeleitet werden, um die Empfindlichkeiten aller ersten optischen Sensoren besser zu berücksichtigen.

Im Fall eines plötzlichen Lichteinfalls oder des Abwischens einer Flüssigkeit von der Abdeckung tritt sowohl am ersten optischen Sensor 12 als auch am zweiten optischen Sensor 20 der gleiche Effekt. Daher kann durch ein Vergleichen des Messwerts des ersten optischen Sensors 12 mit dem Referenzwert des zweiten optischen Sensors 20 einfach festgestellt werden, ob tatsächlich der Tastschalter von einem Benutzer betätigt worden ist oder nur zum Beispiel einer der oben genannten Vorgänge passiert. In einem solchen Fall werden alle unmittelbar voreilenden und nachfolgenden Tastenwechsel durch die Auswerteschaltung unterdrückt.

Um die Funktionssicherheit der elektrischen Schaltvorrichtung weiter zu erhöhen, muss auch gewährleistet sein, dass die zweiten optischen Sensoren 20 nicht fehlerhaft bzw. ausgefallen sind. Zu diesem Zweck ist der eine oder doppelte dritte optische Sensor 22 vorgesehen. Durch einen Vergleich des vom zweiten optischen Sensor 20 erzeugten Referenzwerts mit dem vom dritten optischen Sensor 22 generierten Hauptreferenzwert kann auf einfache Weise eine Fehlfunktion des zweiten optischen Sensors 20 erkannt werden.

Es ist alternativ auch denkbar, jedem zweiten optischen Sensor 20 einen dritten optischen Sensor 22 zuzuweisen. Zum Beispiel können alle zweiten optischen Sensoren 20 aus zwei unmittelbar nebeneinander angeordneten Sensoren aufgebaut sein.

### BEZUGSZIFFERNLISTE

- 10: Abdeckung
- 12: erster optischer Sensor
- 14: Leiterplatte
- 16: Bedruckung von 10
- 18: Anzeigeelement
- 20: zweiter optischer Sensor
- 22: dritter optischer Sensor
- 24: Sender des optischen Sensors 12, 20, 22
- 26: Empfänger des optischen Sensors 12, 20, 22
- 28: Messpunkt

## Patentansprüche

1. Elektrische Schaltvorrichtung, insbesondere zur Bedienung eines Haushaltsgeräts, mit
wenigstens einem berührungsempfindlichen Tastschalter, der einen ersten optischen Sensor (12) aufweist, der hinter einer für die elektromagnetische Strahlung des optischen Sensors zumindest teildurchlässigen Abdeckung (10) angeordnet ist; und
einer Auswerteschaltung zum Auswerten eines von dem ersten optischen Sensor (12) des wenigstens einen Tastschalters zugeführten Messwerts,
**dadurch gekennzeichnet,**
**dass** dem ersten optischen Sensor (12) des wenigstens einen Tastschalters ein zweiter optischer Sensor (20) zugeordnet ist, der ebenfalls hinter der Abdeckung (10) angeordnet ist, zum Erzeugen eines Referenzwerts; und
**dass** die Auswerteschaltung den von dem ersten optischen Sensor (12) des wenigstens einen Tastschalters zugeführten Messwert mit dem von dem zweiten optischen Sensor (20) des wenigstens einen Tastschalters zugeführten Referenzwert vergleicht.

2. Elektrische Schaltvorrichtung nach Anspruch 1,
**dadurch gekennzeichnet,**
**dass** mehrere berührungsempfindliche Tastschalter mit jeweils einem ersten optischen Sensor (12) vorgesehen sind; und
**dass** jedem der ersten optischen Sensoren (12) der mehreren Tastschalter ein zweiter optischer Sensor (20) zugewiesen ist.

3. Elektrische Schaltvorrichtung nach Anspruch 1 oder 2,
**dadurch gekennzeichnet,**
**dass** die Schaltvorrichtung ferner einen dritten optischen Sensor (22), der ebenfalls hinter der Abdeckung (10) angeordnet ist, zum Erzeugen eines Hauptreferenzwerts aufweist; und
**dass** die Auswerteschaltung die von den zweiten optischen Sensoren (20) der Tastschalter zugeführten Referenzwerte mit dem von dem dritten optischen Sensor (22) zugeführten Hauptreferenzwert vergleicht.

4. Elektrische Schaltvorrichtung nach Anspruch 3,
**dadurch gekennzeichnet,**
**dass** die Schaltvorrichtung zwei nebeneinander angeordnete dritte optische Sensoren (22) zum Erzeugen jeweils eines Hauptreferenzwerts aufweist.

5. Elektrische Schaltvorrichtung nach einem der vorhergehenden Ansprüche,
**dadurch gekennzeichnet,**
**dass** jedem ersten optischen Sensor (12) der Tastschalter an der Abdeckung (10) eine Bedruckung (16) zugeordnet ist, während den zweiten und dritten optischen Sensoren (20, 22) keine Bedruckungen an der Abdeckung (16) zugeordnet sind.

6. Elektrische Schaltvorrichtung nach einem der Ansprüche 1 bis 5,
**dadurch gekennzeichnet,**
**dass** die ersten optischen Sensoren (12) und die zweiten optischen Sensoren (20) auf einer gemeinsamen Leiterplatte (14) angeordnet sind.

7. Elektrische Schaltvorrichtung nach einem der Ansprüche 3 bis 5,
**dadurch gekennzeichnet,**
**dass** die ersten optischen Sensoren (12), die zweiten optischen Sensoren (20) und die dritten optischen Sensoren (22) auf einer gemeinsamen Leiterplatte (14) angeordnet sind.

8. Verfahren zum Auswerten eines Messwerts, der von einem ersten optischen Sensor (12) eines berührungsempfindlichen Tastschalters erfasst wird, der hinter einer für die elektromagnetische Strahlung des optischen Sensors zumindest teildurchlässigen Abdeckung (10) angeordnet ist,
**dadurch gekennzeichnet,**
**dass** der von dem ersten optischen Sensor (12) des Tastschalters zugeführte Messwert mit einem von einem zweiten optischen Sensor (20), der dem ersten optischen Sensor (12) des Tastschalters zugeordnet ist, zugeführten Referenzwert verglichen wird.

9. Verfahren nach Anspruch 8,
**dadurch gekennzeichnet,**
**dass** mehrere Messwerte ausgewertet werden, die jeweils von einem ersten optischen Sensor (12) eines Tastschalters erfasst werden; und
**dass** die von den ersten optischen Sensoren (12) der Tastschalter zugeführten Messwerte jeweils mit einem von einem zweiten optischen Sensor (20), der dem ersten optischen Sensor (12) des jeweiligen Tastschalters zugeordnet ist, zugeführten Referenzwert verglichen werden.

10. Verfahren nach Anspruch 8 oder 9,
**dadurch gekennzeichnet,**
**dass** die von den zweiten optischen Sensoren (20) der Tastschalter zugeführten Referenzwerte mit einem von einem dritten optischen Sensor (22) zugeführten Hauptreferenzwert verglichen werden.

11. Verfahren nach einem der Ansprüche 8 bis 10,
**dadurch gekennzeichnet,**
**dass** basierend auf dem Vergleich zwischen dem vom ersten optischen Sensor (12) des Tastschalters zugeführten Messwert und dem vom zweiten optischen Sensor (20) zugeführten Referenzwert eine Fehlfunktion des jeweiligen Tastschalters beurteilt wird.

12. Verfahren nach einem der Ansprüche 8 bis 10,
**dadurch gekennzeichnet,**
**dass** basierend auf dem Vergleich zwischen dem vom ersten optischen Sensor (12) des Tastschalters zugeführten Messwert und dem vom zweiten optischen Sensor (20) zugeführten Referenzwert eine Empfindlichkeit des jeweiligen Tastschalters berücksichtigt wird.

13. Verfahren nach einem der Ansprüche 8 bis 10,
**dadurch gekennzeichnet,**
**dass** basierend auf dem Vergleich zwischen dem vom ersten optischen Sensor (12) des Tastschalters zugeführten Messwert und dem vom zweiten optischen Sensor (20) zugeführten Referenzwert eine fehlerhaft beurteilte Betätigung des jeweiligen Tastschalters erkannt wird.
